# EUROPEAN PATENT SPECIFICATION

(11) **EP 0 497 596 B1**
(45) Date of publication and mention of the grant of the patent: **10.01.1996**
(21) Application number: 92300795.9
(22) Date of filing: 30.01.1992
(51) Int. Cl.: H01L 21/3205

(54) **Method for fabricating integrated circuit structures**
Verfahren zum Herstellen von integrierten Schaltstrukturen
Procédé de fabrication des structures de circuit intégré

(30) Priority: 31.01.1991 US 648650
(43) Date of publication of application: 05.08.1992
(73) Proprietor: SGS-THOMSON MICROELECTRONICS, INC., Carrollton Texas 75006 (US)
(72) Inventor: Liou, Fu-Tai, Carrollton, Texas 75010 (US); Wei, Che-Chia, Plano, Texas 75093 (US)
(74) Representative: Palmer, Roger

(56) References cited:
- EP-A- 0 071 029
- US-A- 4 128 670
- US-A- 4 470 189
- JOURNAL OF THE ELECTROCHEMICAL SOCIETY. vol. 133, no. 11, November 1986,MANCHESTER, NEW HAMPSHIRE US pages 2386 - 2389; M. LIN ET AL.: 'An Environment-Insensitive Trilayer Structure for Titanium Silicide Formation'
- JAPANESE JOURNAL OF APPLIED PHYSICS, SUPPLEMENTS. vol. 20, 1981, TOKYO JA pages49 - 54; S. SAITHO ET AL.: 'Formation of a Double-Hetero Si/CoSi2/Si StructureUsing Molecular Beam and Solid Phase Epitaxies' Supplement 20-1
- IBM TECHNICAL DISCLOSURE BULLETIN. vol. 22, no. 2, July 1979, NEW YORK US pages598 - 599; J.K. HOWARD: 'High Conductivity Transition Metal Silicide (NbSi2)for FET Gate Structures'
- APPLIED PHYSICS LETTERS. vol. 50, no. 14, 6 April 1987, NEW YORK US pages 933 -934; H.T.G. HENTZELL ET AL.: 'Formation of Aluminum Silicide between Two Layersof Amorphous Silicon'

## Description

The present invention relates generally to semiconductor integrated circuit structures, and more specifically to a method for providing low resistance contact and interconnect structures.

In submicron VLSI, polycrystalline silicon interconnect layers and active areas in the substrate are used for providing electrical interconnections between devices formed within the substrate. Use of the active area for interconnect is necessary to achieve the high packing densities required for small geometry, high density circuits.

A process known as SALICIDE (Self-Aligned siliCIDE) has become more commonly used recently as a process which enhances the performance of integrated circuit devices which use active areas for interconnection purposes. This process forms a conductivity enhancing refractory metal silicide layer in the selected active areas of the substrate simultaneously with silicidation of polycrystalline silicon gate and interconnect elements. The silicidation steps used to form these silicides are fairly straight forward and reliable, and are compatible with current standard process flows.

IBM TECHNICAL DISCLOSURE BULLETIN (vol.22, no. 2, July 1979, pp. 598-599) discloses improving the conductivity of poly-Si gate structures using the transition metal silicide NbSi₂.

EP-A-0404372 discloses a semiconductor integrated circuit structure, and a method of manufacturing an integrated circuit, which comprises a first silicon layer, an insulating layer having a contact opening formed over said first silicon layer, a metal silicide layer covering said contact opening and a second polycrystalline silicon layer covering the metal silicide layer and at least a part of the insulating layer.

The silicidation process does have some drawbacks. The process converts underlying silicon to a refractory metal silicide. If the polycrystalline silicon layer used to form the gate is too thin, so that the entire layer is converted to the refractory metal silicide, gate oxide integrities can be degraded. Additionally, the consumption of silicon in the substrate active areas can damage shallow junctions in the substrate. Increasing the thickness of the polycrystalline silicon layer used to form the gates will normally solve any problems relating to the silicidation of the gate and polycrystalline silicon interconnect. However, shallow junction depth is necessary for sub-micron integrated circuits, and the junctions cannot be deepened in most cases.

Approximately the same depth of silicon is consumed in the polycrystalline silicon gate and interconnect elements as in the active areas when the silicidation process is performed. In order to protect the active area junctions, the thickness of the silicide layer must be limited. This also limits the thickness of the silicide which can be formed on the polycrystalline silicon gate and interconnect elements. Since conductivity is improved for thicker silicides, it is normally desirable to provide the thickest possible silicide layer on the gate and interconnect layers which is consistent with gate integrity. However, only relatively thin silicides can be formed in the polycrystalline silicon to ensure that the active area junctions are protected.

It would be desirable to provide a method for forming integrated circuit structures which allows formation of a low resistance polycrystalline silicon silicide element without damaging junctions in the substrate. It would be further desirable for such method to be compatible with current process technologies.

It is therefore an object of the present invention to provide a method for fabricating integrated circuit structures which provides silicided polycrystalline silicon conductive elements and silicided active areas.

It is another object of the present invention to provide such a method which results in the formation of low resistivity polycrystalline silicon elements without damaging shallow active area junctions.

It is a further object of the present invention to provide such a method which is easily implemented using widely available process technologies.

The present invention provides a method for forming a conductive interconnect structure for an integrated circuit formed in a silicon substrate having an active area with shallow junction regions therein, comprising the steps of:
forming a first polycrystalline silicon layer at least over selected areas of said integrated circuit to which interconnection is to be made;
forming a first conductive silicide layer over the first polycrystalline silicon layer;
forming a second polycrystalline silicon layer over the first conductive silicide layer;
characterized in that the method further comprises the steps of:
patterning the first and second polycrystalline silicon layers and the first conductive silicide layer to define a multilayered conductive structure;
forming a layer of metal that reacts to form a conductive silicide over said multilayered conductive structure and exposed regions of said substrate including the active area having shallow junction regions defined therein; and
heating said substrate, said second polycrystalline silicon layer and said layer of metal, said heating being performed at a temperature sufficient to produce a second conductive silicide overlying said first conductive silicide layer and said substrate to a shallow depth without affecting the shallow junction regions in the active area of the substrate.

The present invention also provides a conductive interconnect structure consisting of a portion of a semiconductor integrated circuit comprising:
a multilayered conductive structure having a first polycrystalline silicon layer, a first conducting silicide layer on the first polycrystalline silicon layer, and a second polycrystalline silicon layer on the first conducting silicide layer;
characterised in that the conductive interconnect structure further includes a first conductive region having a conductive silicide layer thereon which has a first thickness, the multilayered conductive structure has a second conducting silicide layer on the second polycrystalline silicon layer, and the second conducting silicide layer has substantially the first thickness and is formed from the same material as the conductive silicide layer on the first conductive region.
According to the present invention, gate and polycrystalline silicon interconnect elements are formed using a sandwich of a highly conductive silicide layer between two polycrystalline silicon layers. Transistors and active areas are defined using standard techniques. A layer of refractory metal is deposited over the integrated circuit device, and heated to form a silicide with exposed monocrystalline and polycrystalline silicon areas. The depth of the silicide formed is not very large, and is consistent with protecting shallow junctions in the active areas of the device. Sheet resistance of the polycrystalline silicon conductive elements is maintained at low levels by the additional silicide layer within the sandwich.

The novel features believed characteristic of the invention are set forth in the appended claims. The invention itself however, as well as a preferred mode of use, and further objects and advantages thereof, will best be understood by reference to the following detailed description of an illustrative embodiment when read in conjunction with the accompanying drawings, wherein:
**Figures 1** - 5 illustrate a preferred method for forming integrated circuit structures according to the present invention; and
**Figure 6** is a plan view of a portion of an integrated circuit structure fabricated in accordance with the present invention.

The process steps and structures described below do not form a complete process flow for manufacturing integrated circuits. The present invention can be practiced in conjunction with integrated circuit fabrication techniques currently used in the art, and only so much of the commonly practiced process steps are included as are necessary for an understanding of the present invention. The figures representing cross-sections of portions of an integrated circuit during fabrication are not drawn to scale, but instead are drawn so as to illustrate the important features of the invention.

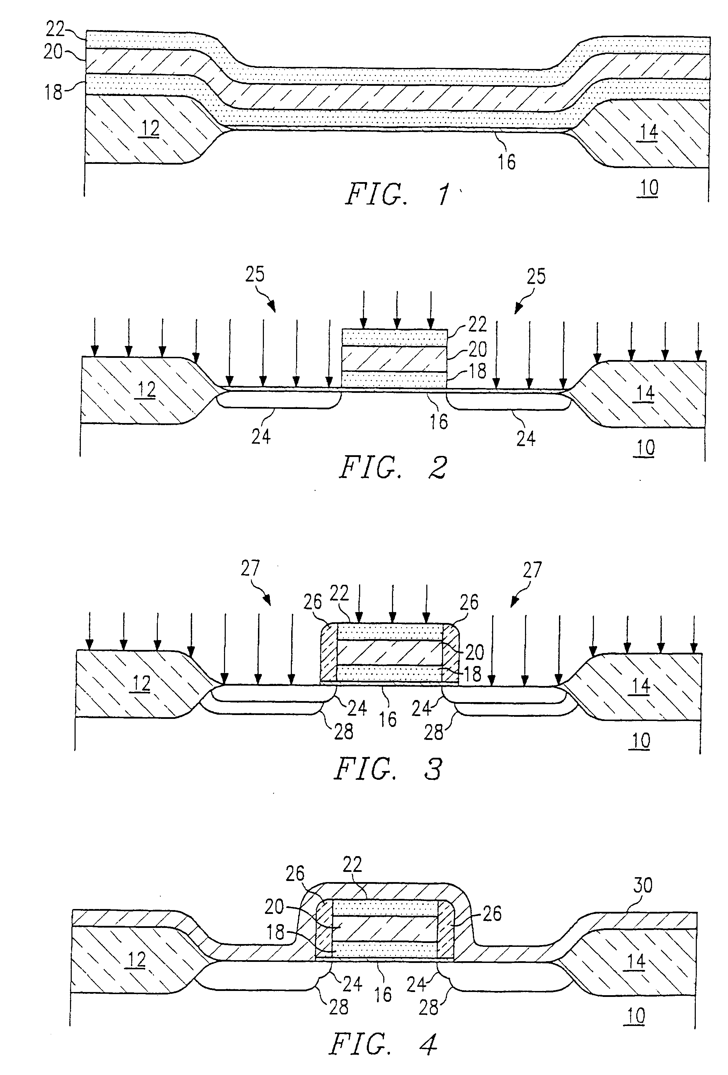

Referring to **Figure 1**, an integrated circuit is to be formed in a semiconductor substrate **10**. Active areas will be defined between field oxide regions **12, 14**. Between the field oxide regions, a gate oxide layer **16** is grown over exposed portions of the substrate **10**. A layer of polycrystalline silicon **18** is then deposited over the surface of the device. A layer of tungsten silicide **20** is deposited over the polycrystalline silicon layer **18**. Tungsten silicide layer **20** is, as known in the art, highly conductive relative to polycrystalline silicon. Tungsten silicide layer **20** may be deposited, as known in the art, or it may be grown by depositing a tungsten layer over the polycrystalline silicon layer **18**, and heating the integrated circuit device to form the silicide layer **20**. If the latter approach is used, silicide formation is then followed by a wet etch to remove unreacted tungsten. A second polycrystalline silicon layer **22** is then formed over the silicide layer **20**.

Both of the polycrystalline silicon layers **18, 22** are preferably doped to improve their conductivity. The level of doping need not be extremely high, inasmuch as the silicide layer **20** will be the primary current carrying structure. However, the polycrystalline silicon layers **18, 22** will likely make contact with other structures containing silicon, and doping the polycrystalline silicon layers **18, 22** can improve the quality of the contact with these other layers. Polycrystalline silicon layers **18, 22** may be initially formed with impurities, or may be doped after deposition by using, for example, ion implantation. If the process herein described is used in the formation of CMOS devices, it may be necessary to dope the polycrystalline silicon layers **18, 22** using ion implantation so that different portions of the layers **18, 22** can be doped P-type and N-type. This doping using different impurities may be necessary to prevent the formation of unwanted PN junctions where polycrystalline silicon layer **18** contacts N-type and P-type regions within the substrate **10**.

Referring to Figure 2, the layers 18,20,22 are patterned and etched to define a gate electrode. Gate oxide 16 is typically used as an etch stop for the polycrystalline silicon layer 18, and is not removed at this time. Lightly doped drain regions 24 are then implanted by an implant 25 into the substrate 10 as known in the art. With reference to Figure 3, a layer of oxide (not shown) is deposited over the surface of the device, and antisotropically etched back to form sidewall regions 26. Formation of the sidewall oxide regions 26 generally removes any exposed portions of the oxide layer 16, resulting in the structure shown in Figure 3.

A high impurity dosage implant 27 is then made to form source/drain regions **28**. These regions **28** fill the active_areas of the device which are not masked by the gate electrode and its sidewalls **26**. In addition to being used as source/drain regions suitable for later contacts, they are also used as current carrying interconnect structures between physically proximate transistors. After formation of the source/drain regions **28**, a layer **30** of refractory metal, preferably titanium, is formed over the surface of the device.

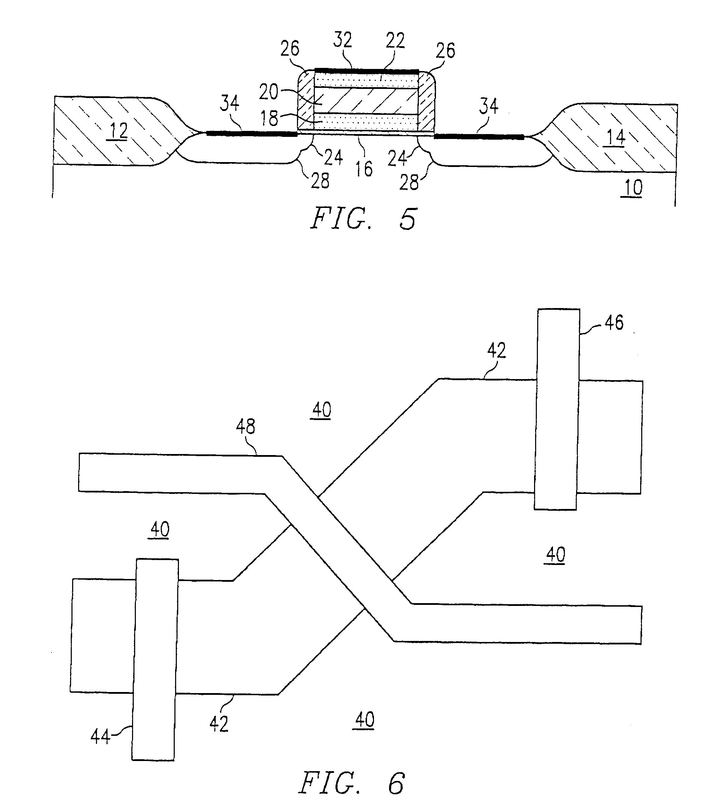

Referring to Figure 5 the titanium layer **30** is then reacted in a nitrogen ambient, as known in the art, to form titanium silicide regions on the gate **32**, and in the active areas **34**. The thickness of the titanium layer **30** and the temperature and duration of the anneal period used to form the silicide are chosen so that the silicide regions **34** do not damage the integrity of the junctions underlying the source/drain regions **28**. Although this provides a thinner than normally desirable silicide region **32** on the gate electrode, the relatively thicker silicide region **20** lowers the overall resistivity of the gate electrode to desirable levels.

Any unreacted titanium and titanium nitride are then stripped from the device. An additional anneal step in a high temperature may be used, if desired, to provide more stable titanium silicide regions **32, 34,** and improve the conductivity of these regions. The remainder of the fabrication process from this point is conventional, and may for example, include the formation of second and third level polycrystalline silicon layers, one or more layers of metal interconnect, and device passivation.

Referring to **Figure 6**, an example is shown of a portion of an integrated circuit layout in which the process as described above can be used to good advantage. Field oxide **40** surrounds an active region **42**. Gate electrode **44** overlies a portion of the active region **42**, with source/drain regions lying to either side thereof. Likewise, gate electrode **46** overlies the active region **42** with source/drain regions lying to either side. The gate electrodes **44, 46** are preferably the same as that shown in **Figure 4**,having two different silicide layers and sidewall oxide spacers as shown in **Figure 4**. A polycrystalline silicon interconnect lead **48** is formed from a second or third level polycrystalline silicon interconnect layer, and crosses over the active region **42**. Since conductive element **48** is formed at a later stage, active area **42** is continuous underneath it. Since the conductive element **48** is spaced above the active area **42** by at least one level of interlevel oxide, and the active area **42** is highly conductive due to its surface being silicided as described above, no field effect transistor is formed underneath the conductive element **48** where it crosses over the active area **42**.

Active area **42** defines a conductive interconnect structure between the source/drain regions of the transistors defined by gate electrodes **44** and **46**. Since it is formed in the substrate, conductive element 48 can be formed in second level polysilicon. This allows the illustrated crisscross arrangement, such as might be found with the crosscoupled latches of an SRAM cell, to be easily fabricated.

Various alternatives to the steps set forth above will become apparent to those skilled in the art. For example, the preferred tungsten silicide conductive layer **20** may be replaced by any other conductive layer, such as another refractory silicide layer or a suitable refractory metal layer. The titanium silicide regions **32, 34** can be formed instead from other refractory metal silicides in the same manner.

Another alternative step is to form the source/drain regions 28 after formation of the silicide regions 32 ,34. The implantation of the source/drain regions 28 is simply delayed until after the SALICIDE step, and the source/drain regions 28 implanted through the silicide regions 34.

The method described above, and the structure formed thereby, provides a technique for performing a SALICIDE process with improved characteristics. A thinner silicide layer is formed over the active areas of the substrate in order to preserve the integrity of shallow junction regions. An extra conductive layer, such as a tungsten silicide layer, is included in the gate and interconnect electrodes to ensure that their conductivity remains high. Although the preferred method is illustrated as being used with a first level polycrystalline silicon layer, it may also be used with polycrystalline silicon interconnect layer in which it is necessary or desirable to use to the SALICIDE process to form a silicide on the silicon layer simultaneously with one in the substrate, in which only a thin layer may be formed. Thus, the technique can be practiced when simultaneously siliciding a second or third layer polycrystalline silicon interconnect and the substrate. It can also be used when simultaneous silicidation must be performed of two or more different polycrystalline silicon interconnect layers, wherein at least one of such layers has only a thin layer of polycrystalline silicon and must not be silicided to a greater thickness.

## Claims

1. A method for forming a conductive interconnect structure for an integrated circuit formed in a silicon substrate (10) having an active area (42) with shallow junction regions therein, comprising the steps of:
forming a first polycrystalline silicon layer (18) at least over selected areas of said integrated circuit to which interconnection is to be made;
forming a first conductive silicide layer (20) over the first polycrystalline silicon layer (18);
forming a second polycrystalline silicon layer (22) over the first conductive silicide layer (20);
characterized in that the method further comprises the steps of:
patterning the first and second polycrystalline silicon layers (18,22) and the first conductive silicide layer (20) to define a multilayered conductive structure;
forming a layer of metal (30) that reacts to form a conductive silicide over said multilayered conductive structure and exposed regions of said substrate (10) including the active area (42) having shallow junction regions defined therein; and
heating said substrate (10), said second polycrystalline silicon layer (22) and said layer of metal (30), said heating being performed at a temperature sufficient to produce a second conductive silicide (32,34) overlying said first conductive silicide layer (20) and said substrate (10) to a shallow depth without affecting the shallow junction regions in the active area (42) of the substrate (10).

2. The method of claim 1, wherein said step of forming a layer of metal (30) that reacts to form a conductive silicide comprises depositing a refractory metal over the surface of the integrated circuit, and further comprising the step of removing any unreacted refractory metal after said heating step.

3. The method of claim 2, wherein the refractory metal comprises titanium, and wherein the first conductive silicide layer (20) comprises tungsten silicide.

4. The method of claim 1, further comprising the step of:
before said first polycrystalline silicon layer forming step, forming a gate oxide layer (16) over at least portions of the integrated circuit, wherein a portion of the multilayered conductive structure provides a gate for a field effect device.

5. The method of claim 4, wherein said patterning step exposes regions of the substrate (10) underlying the gate oxide layer (16), and further comprising the steps of:
after said patterning step, implanting impurities (25) into the substrate (10) to form lightly doped drain regions (24) of the field effect device; and
forming sidewall oxide regions (26) alongside vertical sides of the gate.

6. The method of claim 5, further comprising the step of:
implanting impurities (27) into the substrate (10) to form source/drain regions (28) for the field effect device, the implanting being after said step of forming sidewall oxide regions (26) or after said heating step.

7. The method of claim 1, wherein the first and second conductive silicides (20,32,34) comprise refractory metal silicides.

8. The method of claim 7, wherein the first and second conductive silicides (20,32,34) are conductive metal silicides containing different refractory metals.

9. A conductive interconnect structure consisting of a portion of a semiconductor integrated circuit comprising:
a multilayered conductive structure having a first polycrystalline silicon layer (18) , a first conducting silicide layer (20) on the first polycrystalline silicon layer (18), and a second polycrystalline silicon layer (22) on the first conducting silicide layer (20);
characterised in that the conductive interconnect structure further includes a first conductive region having a conductive silicide layer (34) thereon which has a first thickness, the multilayered conductive structure has a second conducting silicide layer (32) on the second polycrystalline silicon layer (22), and the second conducting silicide layer (32) has substantially the first thickness and is formed from the same material as the conductive silicide layer (34) on the first conductive region.

10. The structure of claim 9, wherein the multilayered conductive structure defines a gate for a field effect device.

11. The structure of claim 10, has sidewall oxide spacers (26) on vertical sides of the gate.

12. The structure of claim 11, further comprising:
a second conductive region having a conductive silicide layer (34) thereon which has a first thickness;
wherein said first and second conductive regions define active regions in a substrate (10), and are spaced on opposite sides of the gate to define source/drain regions.

13. The structure of claim 9, wherein said first conductive region lies in a substrate (10) and defines a conductive path between two field effect devices.

14. The structure of claim 13, further comprising:
a conducting polycrystalline silicon interconnect element (48) which crosses said first conductive region (34), and is separated therefrom by an insulating layer.

## Patentansprüche

1. Verfahren zum Ausbilden einer leitenden Zwischenverbindungsstruktur für eine integrierte Schaltung, die in einem Siliziumsubstrat (10) ausgebildet ist, die einen aktiven Bereich (42) mit flachen Verbindungs- bzw. Verzweigungsbereichen darin aufweist, mit den folgenden Schritten:
eine erste Schicht aus polykristallinem Silizium (18) wird zumindest über ausgewählten Bereichen der integrierten Schaltung ausgebildet, zu welchen eine Zwischenverbindung herzustellen ist;
eine erste leitende Siliziumschicht (20) wird über der ersten polykristallinen Siliziumschicht (18) ausgebildet;
eine zweite Schicht (22) aus polykristallinem Silizium wird über der ersten leitenden Siliziumschicht (20) ausgebildet;
dadurch **gekennzeichnet**, daß das Verfahren ferner folgende Schritte aufweist:
die erste und die zweite Schicht (18, 22) aus polykristallinem Silizium und die erste leitende Siliziumschicht (20) werden mit einem Muster versehen, um eine mehrschichtige leitende Struktur festzulegen;
eine Schicht aus Metall (30) wird ausgebildet, die reagiert, um ein leitendes Silizid über der mehrschichtigen leitenden Struktur und freigelegten Bereichen des Substrats (10) auszubilden, die den aktiven Bereich (42) enthalten, der die darin festgelegten flachen Verbindungs- bzw. Anschlußbereiche aufweist; und
das Substrat (10), die zweite Schicht (22) aus polykristallinem Silizium und die Metallschicht (30) werden erhitzt, wobei die Erhitzung bei einer Temperatur durchgeführt wird, die ausreicht, um ein zweites leitendes Silizid (32, 34) zu erzeugen, das die erste leitende Silizidschicht (20) und das Substrat (10) bis zu einer flachen Tiefe überdeckt, ohne die flachen Verbindungs- bzw. Anschlußbereiche in dem aktiven Bereich (42) des Substrats (10) zu beeinträchtigen.

2. Verfahren nach Anspruch 1, in dem der Schritt des Ausbildens einer Metallschicht (30), die reagiert, um ein leitendes Silizid auszubilden, aufweist, daß ein hochschmelzendes Metall bzw. schlecht entflammbares Metall über der Oberfläche der integrierten Schaltung abgeschieden wird, und ferner den Schritt aufweist, nicht durch eine Reaktion verarbeitetes hochschmelzendes bzw. schwer entflammbares Metall nach dem Erhitzungsschritt zu entfernen.

3. Verfahren nach Anspruch 2, in dem das hochschmelzende bzw. schwer entflammbare Metall Titan aufweist und in dem die erste leitende Silizidschicht (20) Wolframsilizid aufweist.

4. Verfahren nach Anspruch 1, das ferner folgenden Schritt aufweist:
vor dem Schritt zum Ausbilden der ersten Schicht aus polykristallinem Silizium wird eine Gateoxidschicht (16) über zumindest Abschnitten der integrierten Schaltung ausgebildet, wobei ein Abschnitt der mehrschichtigen leitenden Struktur ein Gate für eine Feldeffekteinrichtung zur Verfügung stellt.

5. Verfahren nach Anspruch 4, in dem der Schritt zum Ausbilden eines Musters Bereiche des Substrats (10) freilegt, die die Gateoxidschicht (16) unterlegen und ferner folgende Schritte aufweist:
nach dem Schritt zur Ausbildung eines Musters werden Verunreinigungen bzw. Dotierungsstoffe (25) in das Substrat (10) implantiert, um leicht dotierte Drainbereiche (24) der Feldeffekteinrichtungen auszubilden; und
Seitenwandoxidbereiche (26) werden entlang der Seiten bzw. Kanten vertikaler Seiten des Gates ausgebildet.

6. Verfahren nach Anspruch 5, das ferner folgenden Schritt aufweist:
Verunreinigungen bzw. Dotierstoffe (27) werden in das Substrat (10) implantiert, um Source-/Drainbereiche (28) für die Feldeffekteinrichtung auszubilden, wobei die Implantierung nach dem Schritt zum Ausbilden der Seitenwandoxidbereiche (26) oder nach dem Erhitzungsschritt vorgesehen ist.

7. Verfahren nach Anspruch 1, in dem die ersten und zweiten leitenden Silizide (20, 32, 34) ein hochschmelzendes bzw. schwer entflammbares Metallsilizid aufweisen.

8. Verfahren nach Anspruch 7, in dem die ersten und zweiten leitenden Silizide (20, 32, 34) leitende Metailsilizide sind, die verschiedene hochschmelzende bzw. schwer entflammbare Metalle enthalten.

9. Leitende Zwischenverbindungs- bzw. Zwischenanschlußstruktur, die aus einem Abschnitt einer integrierten Halbleiterschaltung besteht, die aufweist:
eine mehrschichtige leitende Struktur, die eine erste Schicht (18) aus polykristallinem Silizium, eine erste leitende Silizidschicht (20) auf der ersten polykristallinen Siliziumschicht (18) und eine zweite Schicht (22) aus polykristallinem Silizium auf der ersten leitenden Silizidschicht (20) aufweist;
dadurch **gekennzeichnet**, daß die leitende Zwischenverbindungs- bzw. Zwischenanschlußstruktur ferner einen ersten leitenden Bereich enthält, der eine leitende Silizidschicht (34), die eine erste Dicke hat, darauf aufweist, wobei die mehrschichtige leitende Struktur eine zweite leitende Silizidschicht (32) auf der zweiten Schicht (22) aus polykristallinem Silizium hat, und die zweite leitende Silizidschicht (32) im wesentlichen die erste Dicke hat und von dem gleichen Material ausgebildet ist, wie die leitende Silizidschicht (34) auf dem ersten leitenden Bereich.

10. Struktur nach Anspruch 9, in der die mehrschichtige leitende Struktur ein Gate für eine Feldeffekteinrichtung festlegt.

11. Struktur nach Anspruch 10, die Seitenwandoxidabstandshalter (26) auf vertikalen Seiten des Gates aufweist.

12. Struktur nach Anspruch 11, die ferner aufweist:
einen zweiten leitenden Bereich, der eine leitende Silizidschicht (34) darauf aufweist, die eine erste Dicke hat;
wobei die erste und die zweite leitende Schicht aktive Bereich in einem Substrat (10) festlegen und auf gegenüberliegenden Seiten des Gates zueinander beabstandet sind, um Source-/Drainbereiche zu definieren.

13. Struktur nach Anspruch 9, in der der erste leitende Bereich in einem Substrat (10) liegt und einen leitenden Pfad zwischen zwei Feldeffekteinrichtungen festlegt.

14. Struktur nach Anspruch 13, die ferner aufweist:
ein leitendes Zwischenverbindungs- bzw. Zwischenanschlußelement (48) aus polykristallinem Silizium, das den ersten leitenden Bereich (34) überkreuzt bzw. überquert und davon durch eine isolierende Schicht getrennt ist.

## Revendications

1. Procédé pour former une structure conductrice d'interconnexion pour un circuit intégré formé dans un substrat de silicium (10) ayant une zone active (42) contenant des zones de jonction peu profondes, comprenant les étapes suivantes :
formation d'une première couche de silicium polycristallin (18) au moins sur des zones sélectionnées dudit circuit intégré pour lequel l'interconnexion est à réaliser ;
formation d'une première couche conductrice de siliciure (20) sur la première couche de silicium polycristallin (18) ;
formation d'une seconde couche de silicium polycristallin (22) sur la première couche conductrice de siliciure (20) ;
caractérisé en ce que le procédé comprend, en plus, les étapes suivantes :
formation de motifs sur les première et seconde couches de silicium polycristallin (18, 22) et sur la première couche conductrice de siliciure (20) pour définir une structure conductrice multicouches ;
formation d'une couche de métal (30) qui réagit pour former un siliciure conducteur sur ladite structure conductrice multicouches et sur les régions exposées dudit substrat (10) incluant la zone active (42) ayant des régions de jonction peu profondes définies en son sein ; et
chauffage dudit substrat (10), de ladite seconde couche de silicium polycristallin (22) et de ladite couche de métal (30), ledit chauffage étant effectué à une température suffisante pour produire un second siliciure conducteur (32, 34) recouvrant ladite première couche conductrice de siliciure (20) et ledit substrat (10) à une profondeur superficielle sans affecter les régions de jonction peu profondes dans la zone active (42) du substrat (10).

2. Procédé selon la revendication 1, dans lequel ladite étape de formation d'une couche de métal (30), qui réagit pour former un siliciure conducteur, comprend le dépôt d'un métal réfractaire sur la surface du circuit intégré, et comprenant, en plus, l'étape d'enlèvement de tout métal réfractaire n'ayant pas réagi après ladite étape de chauffage.

3. Procédé selon la revendication 2, dans lequel le métal réfractaire est constitué de titane, et dans lequel la première couche conductrice de siliciure (20) est constituée de siliciure de tungstène.

4. Procédé selon la revendication 1, comprenant, de plus, l'étape suivante :
avant l'étape de formation de ladite première couche de silicium polycristallin, formation d'une couche d'oxyde de la grille (16) sur au moins des parties du circuit intégré, dans lequel une partie de la structure conductrice multicouches réalise une grille pour un dispositif à effet de champ.

5. Procédé selon la revendication 4, dans lequel ladite étape de formation de motifs expose des régions du substrat (10) sous-jacentes à la couche d'oxyde de la grille (16), et comprenant, de plus, les étapes suivantes :
après ladite étape de formation de motifs, implantation d'impuretés (25) dans le substrat (10) pour former des régions de drain légèrement dopées (24) du dispositif à effet de champ ; et
formation de régions d'oxyde de paroi latérale (26) le long des côtés verticaux de la grille.

6. Procédé selon la revendication 5, comprenant, de plus, l'étape suivante :
implantation d'impuretés (27) dans le substrat (10) pour former des régions source/drain (28) pour le dispositif à effet de champ, l'implantation étant après ladite étape de formation des régions d'oxyde de paroi latérale (26) ou après ladite étape de chauffage.

7. Procédé selon la revendication 1, dans lequel les premier et second siliciures conducteurs (20, 32, 34) contiennent des siliciures de métal réfractaire.

8. Procédé selon la revendication 7, dans lequel les premier et second siliciures conducteurs (20, 32, 34) sont des siliciures de métal conducteur contenant différents métaux réfractaires.

9. Structure conductrice d'interconnexion comprenant d'une partie d'un circuit intégré à semiconducteur comprenant :
une structure conductrice multicouches ayant une première couche de silicium polycristallin (18), une première couche conductrice de siliciure (20) sur la première couche de silicium polycristallin (18), et une seconde couche de silicium polycristallin (22) sur la première couche conductrice de siliciure (20) ;
caractérisé en ce que la structure conductrice d'interconnexion comprend, en plus, une première région conductrice ayant une couche conductrice de siliciure (34) sur cette dernière qui a une première épaisseur, la structure conductrice multicouches possède une seconde couche conductrice de siliciure (32) sur la seconde couche de silicium polycristallin (22), et la seconde couche conductrice de siliciure (32) a sensiblement la première épaisseur et est formée à partir de la même matière que la couche conductrice de siliciure (34) sur la première région conductrice.

10. Structure selon la revendication 9, dans laquelle la structure conductrice multicouches définit une grille pour un dispositif à effet de champ.

11. Structure selon la revendication 10, qui possède des dispositifs d'écartement d'oxyde de paroi latérale (26) sur les côtés verticaux de la grille.

12. Structure selon la revendication 11, comprenant, de plus :
une seconde région conductrice ayant une couche conductrice de siliciure (34) sur cette dernière qui a une première épaisseur ;
dans laquelle lesdites première et seconde régions conductrices définissent des régions actives dans un substrat (10), et sont espacées sur des côtés opposés de la grille pour définir des régions source/drain.

13. Structure selon la revendication 9, dans laquelle ladite première région conductrice repose sur un substrat (10) et définit un chemin conducteur entre deux dispositifs à effet de champ.

14. Structure selon la revendication 13, comprenant, de plus :
un élément conducteur d'interconnexion de silicium polycristallin (48) qui traverse ladite première région conductrice (34), et qui est séparé de cette dernière par une couche isolante.
